# EUROPÄISCHE PATENTSCHRIFT

(11) **EP 0 664 049 B1**
(45) Veröffentlichungstag und Bekanntmachung des Hinweises auf die Patenterteilung: **14.10.1998**
(21) Anmeldenummer: 94925386.8
(22) Anmeldetag: 25.07.1994
(51) Int. Cl.: H01L 21/00

(54) **TRANSPORTVORRICHTUNG FÜR MAGAZINE ZUR AUFNAHME SCHEIBENFÖRMIGER OBJEKTE**
CONVEYOR FOR MAGAZINES RECEIVING DISK-SHAPED OBJECTS
DISPOSITIF DE TRANSPORT POUR MAGASINS DESTINES A CONTENIR DES OBJETS SE PRESENTANT SOUS FORME DE DISQUES

(30) Priorität: 05.08.1993 DE 4326308
(43) Veröffentlichungstag der Anmeldung: 26.07.1995
(73) Patentinhaber: JENOPTIK Aktiengesellschaft, 07739 Jena (DE)
(72) Erfinder: LUDWIG, Joachim, D-07745 Jena (DE)
(74) Vertreter: Geyer, Werner, Dr.-Ing.
(86) Internationale Anmeldenummer: EP9402446
(87) Internationale Veröffentlichungsnummer: WO9505002

(56) Entgegenhaltungen:
- EP-A- 0 273 226
- EP-A- 0 313 693
- WO-A-92/07759

## Beschreibung

Die Erfindung betrifft eine Transportvorrichtung für Magazine zur Aufnahme scheibenförmiger Objekte, bestehend aus einem Magazinbehälter, der mit einem entriegelbaren Boden und einer Absetzfläche seiner Wandung auf eine Aufnahmeplatte einer Einhausung für einen Reinstraum abstellbar ist, wobei die Aufnahmeplatte ein absenkbares, den Boden mit dem Wafermagazin tragendes Plattenteil aufweist. Bei dem Magazinbehälter handelt es sich um eine SMIF-Box, deren Einsatz bevorzugt bei der Herstellung von Halbleiterchips erfolgt.

Unter dem Namen SMIF (Standard Mechanical Interface) bekannt gewordene Systeme beinhalten eine sogenannte SMIF- Box als Magazinbehälter mit einem abgeschlossenen Volumen, in dem Wafermagazine aufbewahrt und transportiert werden können. Die SMIF-Box besitzt einen entriegelbaren Boden und wird auf eine Aufnahmeplatte einer Einhausung für einen Reinstraum so abgesetzt, daß anhaftende Staubpartikel zwischen dem Boden der SMIF-Box und einem, in den Reinstraum absenkbaren Plattenteil eingeschlossen werden. Die Box selbst umschließt die entstehende Öffnung in der Einhausung.
Eine Transportvorrichtung der oben genannten Art ist beispielsweise aus der US 5 169 272 bekannt.

Bei einer Reihe von Prozeßschritten der Halbleiterchipherstellung ist es auf Grund immer höherer Qualitätsanforderungen notwendig, innerhalb der Einhausung unter einer, dem Herstellungsprozeß angepaßten Gasatmosphäre zu arbeiten, von deren Güte das Herstellungsergebnis in entscheidendem Maße beeinflußt wird.
Soll beim Öffnen der Box eine Störung dieser Gasatmosphäre vermieden werden, ist es erforderlich, in der Box gleichartige atmosphärische Bedingungen oder einen Zustand herzustellen, der die Gasatmatmosphäre unbeeinflußt läßt.

Zur Gewährleistung derartiger angepaßter Bedingungen sind in dem US-Patent 5 169 272 ein Verfahren und eine Vorrichtung beschrieben, die zum Reinigen der SMIF-Box ein schrittweises Absenken des entriegelbaren Bodens, verbunden mit der Erzeugung von Druckunterschieden vorsehen. Der erzeugte Druckunterschied verhindert einen Gaseintritt in den Reinstraum beim Absenkvorgang und während der Reinigung der SMIF-Box mit Gas, das im Bereich des Bodens von einer Seite der SMIF-Box zur gegenüberliegenden geführt wird.

Von Nachteil an dieser Lösung ist die unvollkommene Durchströmung des Boxinnenraums, so daß ein Erreichen eines erforderlichen Konzentrationsgefälles in einer akzeptablen Zeit nicht gewährleistet ist.
Andererseits erfordern z.B. Hochtemperaturprozesse eine Entfernung von Sauerstoff. Da der üblicherweise zum Spülen verwendete Stickstoff schwerer ist als der Sauerstoff bzw. das Sauerstoff-Stickstoff-Gemisch, ist eine ausreichende Konzentrationsänderung Stickstoffzu Sauerstoff fraglich.

Werden Box und Magazin in einer Schleuse mit Gas gespült, ist der Gasverbrauch um ein Vielfaches höher und die Spülzeit wesentlich länger.

Im US-Patent Nr. 4 724 874 ist ein Kanal vorgesehen, der den Innenraum der SMIF-Box direkt mit einem außerhalb liegenden Bereich verbindet. Über den Kanal kann in der SMIF-Box ein Vakuum oder ein Überdruck erzeugt sowie ein Gastransport in den Innenraum erfolgen.
Die technische Lösung ist nicht dazu geeignet, effektiv einen Gasaustausch innerhalb der SMIF-Box durchzuführen. Zur Erreichung einer zulässigen Restkonzentration eines Schadgases in einem Prozeßgas wird trotz eines hohen technischen Aufwandes eine relativ lange Zeit benötigt.

Desweiteren ist nach EP 273 226 A2 ein nach äußeren Abmessungen standardisierter, verschließbarer und staubdichter Transportbehälter bekannt, dessen Halbleiterscheibenhalter unter Vermeidung von Reibung beweglich in der Innenhaube angeordnet ist. Zur Gewährleistung einer partikelfreien Luftströmung bei schwankenden Druckverhältnissen dienen Öffnungen in einer äußeren und einer inneren Bodenplatten sowie ein Filterelement an der inneren Bodenplatte.
Die lediglich dem Druckausgleich dienenden Mittel sind zur Erzeugung einer dem Herstellungsprozeß angepaßten Gasatmosphäre im Transportbehälter ungeeignet.

Die Aufgabe der Erfindung besteht darin, mit geringem technischen Aufwand einen zeitlich effektiven Gasaustausch innerhalb einer SMIF-Box in erforderlichem Umfang zu gewährleisten, der sich in das mit einem SMIF-System verbundene Arbeitsregime einpaßt.

Gemäß der Erfindung wird die Aufgabe durch eine Transportvorrichtung nach Anspruch 1 gelöst.

Mit der erfindungsgemäßen Lösung ist durch Ausnutzung eines über den gesamten Innenraum der SMIF-Box verteilten Spülvorganges der Gasaustausch in weitem Maße vollständig, setzt sofort nach dem Aufsetzen der SMIF-Box ein und ist in kürzester Zeit abgeschlossen.

Es ist von Vorteil, wenn die Mittel zur Gasverteilung aus einer an der Wandung lösbar befestigten Ausströmleiste bestehen, die dicht mit dem Gaszufuhrkanal verbunden ist und in die im wesentlichen auf Räume zwischen den scheibenförmigen Objekten und benachbart zur Grund- und Deckfläche des Magazins gerichtete Öffnungen zur Gasverteilung eingearbeitet sind. Der Gasauslaß besteht aus einer an der Wandung lösbar befestigten, Öffnungen zur Gasableitung aufweisenden Ableitungsleiste, die dicht mit dem Gasableitungskanal verbunden ist. Die Kanäle enden an der Absetzfläche in selbstschließenden Ventilen, deren Öffnung beim Absetzen des Magazinbehälters durch Rohrstücke erfolgt, die der Absetzfläche zugewandt aus der Aufnahmeplatte ragen.
Vom Rohrstück zur Öffnung des Ventils am Gaszufuhrkanal besteht eine Verbindung zu einer Gasquelle und vom Rohrstück zur Öffnung des Ventils am Gasableitungskanal zu einem Vakuum. Sowohl der Gasaustritt aus der Gasquelle als auch die Verbindung zu dem Vakuum werden durch einen beim Absetzen des Magazins betätigten Taster geregelt.

Vorteilhaft ist es auch, wenn als Mittel zur Gasverteilung ein erweiterter Einströmraum, dessen Begrenzungen durch abgewinkelte Teile der Wandung gebildet werden und ein dem Einströmraum in Strömungsrichtung nachgeordneter, auf dem entriegelbaren Boden befestigter Diffuser vorgesehen sind, und wenn der Gasauslaß aus einem Gasableitungskanal besteht, der über einen, durch abgewinkelte Teile der Wandung gebildeten erweiterten Ausströmraum mit dem Innenraum des Magazinbehälters in Verbindung steht.

Der Gaszufuhrkanal und der Gasableitungskanal können durch gasdruckbetätigbare Einströmventile verschließbar oder mit Verschlüssen versehen sein, zu deren Betätigung linear bewegliche, mit einer Öffnungen für einen Gasaus- und -eintritt versehene Teile von Andockvorrichtungen dienen.

Die Erfindung soll nachstehend anhand der schematischen Zeichnung näher erläutert werden. Es zeigen:
- Fig. 1: eine Draufsicht in vereinfachter Darstellung auf einen Magazinbehälter in Form einer SMIF-Box
- Fig. 2: erste Einrichtungen zur Gaszufuhr in einem abgesetzten Magazinbehälter

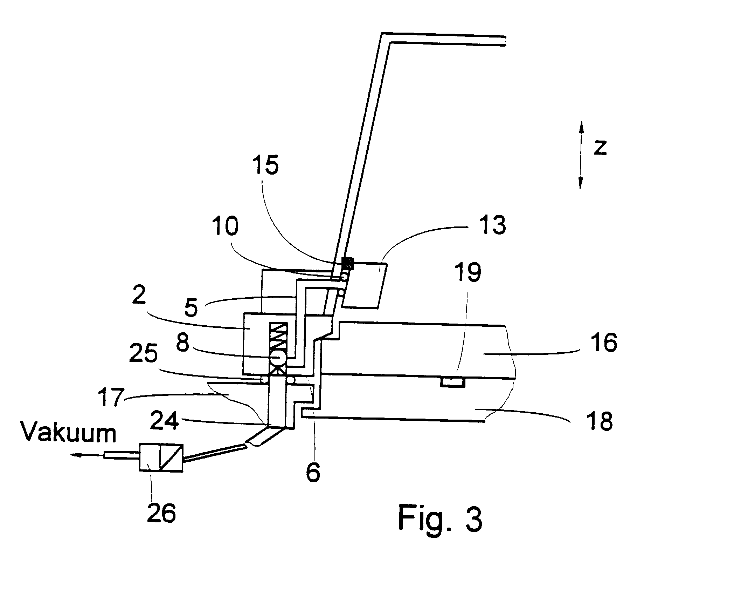

- Fig. 3: erste Einrichtungen zur Gasableitung in einem abgesetzten Magazinbehälter
- Fig. 4: einen abgesetzten Magazinbehälter mit zweiten Einrichtungen zur Gaszufuhr und Gasableitung
- Fig. 5: die zweiten Einrichtungen zur Gaszufuhr in vergrößerter Darstellung
- Fig. 6: die zweiten Einrichtungen zur Gasableitung in vergrößerter Darstellung
- Fig. 7: einen abgesetzten Magazinbehälter mit dritten Einrichtungen zur Gaszufuhr und Gasableitung
- Fig. 8: die dritten Einrichtungen zur Gaszufuhr in vergrößerter Darstellung
- Fig. 9: die dritten Einrichtungen zur Gasableitung in vergrößerter Darstellung
Ein als SMIF-Box 1 ausgebildeter Magazinbehälter umschließt mit seiner Wandung 2 ein Magazin 3 zur Aufnahme scheibenförmiger Objekte, wie z.B. Halbleiterwafer.
Innerhalb der Wandung 2 sind ein Gaszufuhrkanal 4 und ein Gasableitungskanal 5 eingearbeitet, deren Enden an einer Absetzfläche 6 mit selbstschließenden Ventilen 7, 8 versehen und im Austrittsbereich in den Behälterinnenraum von Dichtungen 9, 10 umschlossen sind.
Außerdem umschließt die Dichtung 9 eine nicht dargestellte Gaseintrittsöffnung einer Ausströmleiste 11, über die der Gaszufuhrkanal 4 in Öffnungen zur Gasverteilung mündet. Zu Reinigungszwecken, sowohl des Behälterinnenraumes als auch der Ausströmleiste 11 selbst, ist diese leicht lösbar an Halterungen 12 befestigt. Die Öffnungen zur Gasverteilung sind auf Räume zwischen senkrecht zu einer Bewegungsrichtung z im Magazin 3 eingelagerten scheibenförmigen Objekten und benachbart zur Grund- und Deckfläche des Magazins 3 gerichtet.

Mit der Dichtung 10 liegt der Gasableitungskanal 5 an einer nicht dargestellten Gasaustrittsöffnung einer Ableitungsleiste 13 an und ist so mit Öffnungen zur Gasableitung 14 gekoppelt, die im Bodenbereich der SMIF-Box 1 dem Magazin 3 entgegengesetzt den Öffnungen zur Gasverteilung benachbart sind. Die Öffnungen zur Gasableitung 14 sind Bestandteil der Ableitungsleiste 13, die ebenfalls wie die Ausströmleiste 11 leicht lösbar, d.h. ohne Lösen von Verbindungselementen, aus der SMIF-Box 1 herausnehmbar ist. Entsprechende Halterungen sind mit 15 bezeichnet. Die SMIF-Box 1 ist mit einem entriegelbaren Boden 16 und mit der Absetzfläche 6 auf einer Aufnahmeplatte 17, die einen absenkbaren Plattenteil 18 besitzt, abgestellt. Zwischen dem Boden 16 und dem Plattenteil 18 vorgesehene Mikrotaster 19 dienen der Steuerung des Gasaustritts aus einer Gasquelle 20 sowie zur Ventilsteuerung für einen Vakuumanschluß. Zur Gasquelle 20 besteht eine Verbindung von einem Rohrstück 21, das der Absetzfläche 6 zugewandt, aus der Aufnahmeplatte 17 ragt und das Ventil 7 betätigt. Eine Dichtung 22 sorgt für eine dichte Verbindung. Ein Filter 23 dient der Reinigung des Gases aus der Gasquelle 20.
Zur Betätigung des Ventils 8 ist ein Rohrstück 24 vorgesehen, das wie das Rohrstück 21 aus der Aufnahmeplatte 17 ragt und von einer Dichtung 25 umschlossen ist. Zu einem Vakuum besteht eine Verbindung über ein elektromagnetisches Pneumatikventil 26.

Im abgesetzten Zustand liegt der Boden 16 auf dem Plattenteil 18 auf und betätigt die Mikrotaster 19, deren Signal ein in der Gasquelle 20 vorhandenes elektromagnetisches Pneumatikventil sowie das Pneumatikventil 26 öffnet. In der Folge strömt durch den Filter 23 gereinigtes Gas über das geöffnete Ventil 7 und den Gaszufuhrkanal 4 in die Ausströmleiste 11, die über die Öffnungen zur Gasverteilung Gasströme auf den gesamten Innenraum der SMIF-Box 1 und zur gegenüberliegenden Wandungsseite gerichtet verteilt.
Dadurch erfolgt ein effektiver Gasaustausch in der gesamten SMIF-Box 1.
Abgeleitet wird das Gas über die Öffnungen zur Gasableitung 14, den Gasableitungskanal 5, das geöffnete Ventil 8 und das Rohrstück 24.
Beim Abnehmen der SMIF-Box 1 von der Aufnahmeplatte 17 werden die Ventile 7 und 8 selbsttätig geschlossen. Die Pneumatikventile schließen entweder durch das Signal der Mikrotaster 19 oder ein Signal, das beim Absenken des Plattenteils 16 gebildet wird. Letzterer Fall bedeutet, daß der Gasstrom bei geöffneter SMIF-Box 1 unterbrochen wird.

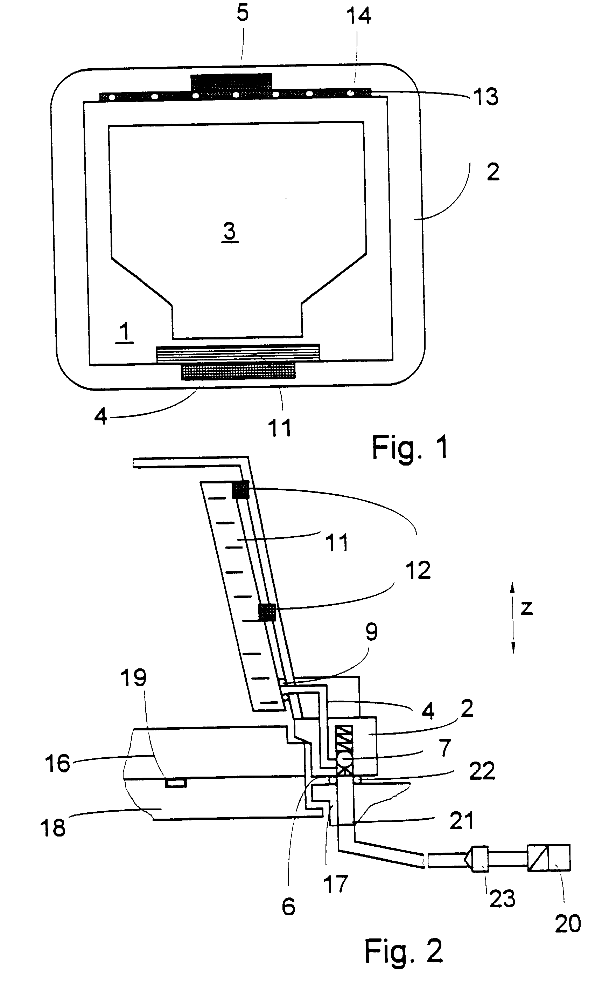

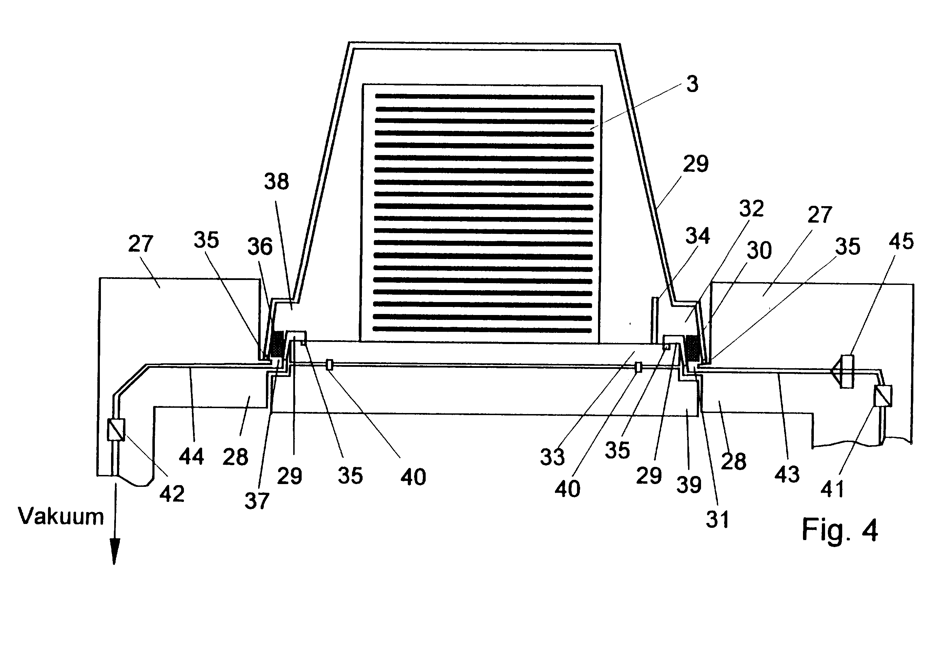

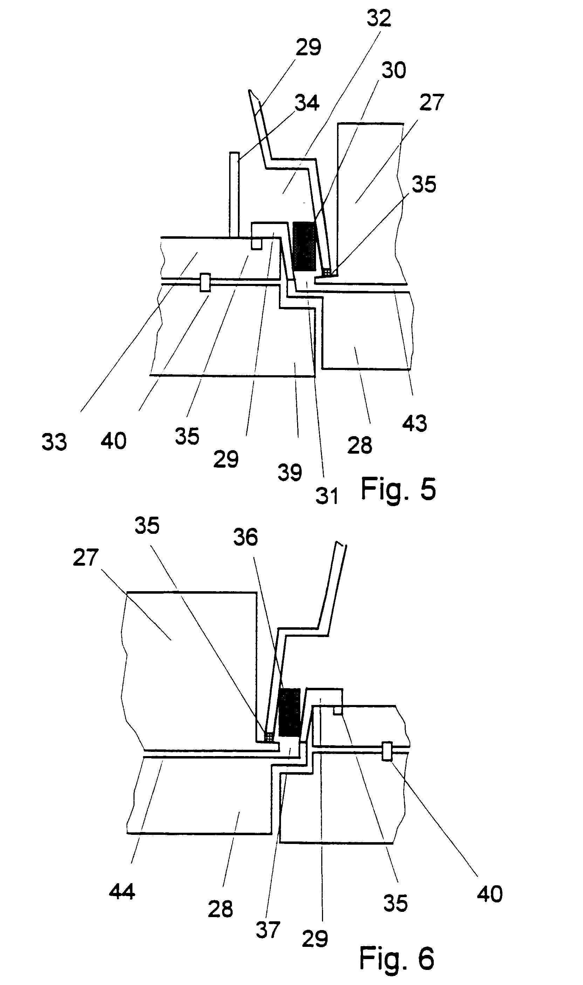

Eine weitere Ausführung der Erfindung sieht entsprechend den Figuren 4 - 6 eine seitlich durch Führungsschienen 27 gehaltene und auf eine Aufnahmeplatte 28 gestellte SMIF-Box vor, in deren Wandung 29 das Magazin 3 an einer Seite benachbart ein durch ein gasdruckbetätigbares Einströmventil 30 verschließbarer Gaszufuhrkanal 31 eingearbeitet ist. Der Gaszufuhrkanal 31 mündet in Mitteln zur Gasverteilung, deren Bestandteile ein erweiterter Einströmraum 32, dessen Begrenzungen durch abgewinkelte Teile der Wandung 29 gebildet werden und ein dem Einströmraum 32 nachgeordneter, auf einem entriegelbaren Boden 33 befestigter Diffuser 34 sind. Dichtungen 35 sorgen für eine dichte Verbindung.
Entgegengesetzt den Mitteln zur Gasverteilung ist dem Magazin 3 benachbart in der Wandung 29 ein durch ein ebenfalls gasdruckbetätigbares Ausströmventil 36 verschließbarer Gasableitungskanal 37 eingearbeitet, der über einen, durch abgewinkelte Teile der Wandung 29 gebildeten erweiterten Ausströmraum 38 mit dem Innenraum der SMIF-Box in Verbindung steht.
Wie bereits für die Ausführung gemäß Fig. 1 und 2 beschrieben, wird im abgesetzten Zustand der SMIF-Box, bei dem der Boden 33 auf einem absenkbaren Plattenteil 39 der Aufnahmeplatte 28 aufliegt, Druckschalter 40 betätigt, so daß ein dadurch erzeugtes Signal elektromagnetische Pneumatikventile 41, 42 in Gasleitungen 43, 44 öffnet.
Ein Gasstrom von einer nicht dargestellten Gasquelle strömt durch die Gasleitung 43, wird gefiltert durch ein Filter 45 und gelangt in den Gaszufuhrkanal 31. Durch den Gasdruck wird das Einströmventil 30 geöffnet und der Gasstrom gelangt in den Einströmraum 32, in dem eine Umlenkung auf den Diffuser 34 erfolgt. Der Diffuser 34 erzeugt eine gleichmäßige Durchströmung des Innenraumes der SMIF-Box und des darin befindlichen Magazins, vorzugsweise auf die Räume zwischen Halbleiterscheiben in dem Magazin 3 und benachbart zur Grund- und Deckfläche.
Über den Ausströmraum 38 und das durch anliegenden Unterdruck geöffnete Ausströmventil 36 tritt das Gas durch den Gasableitungskanal 37 in die Gasleitung 44.

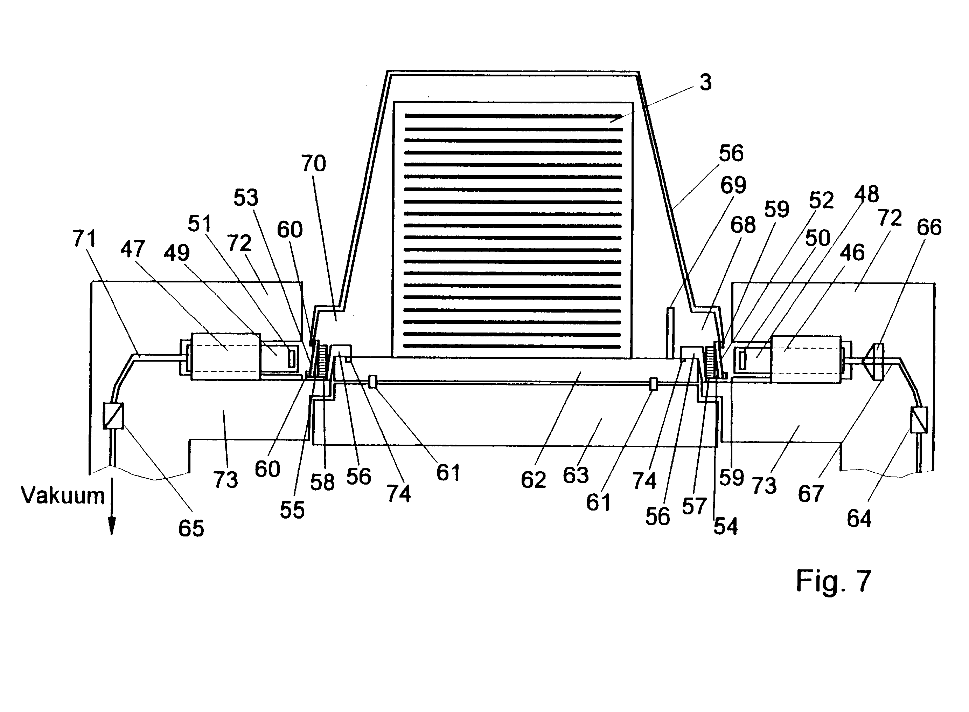

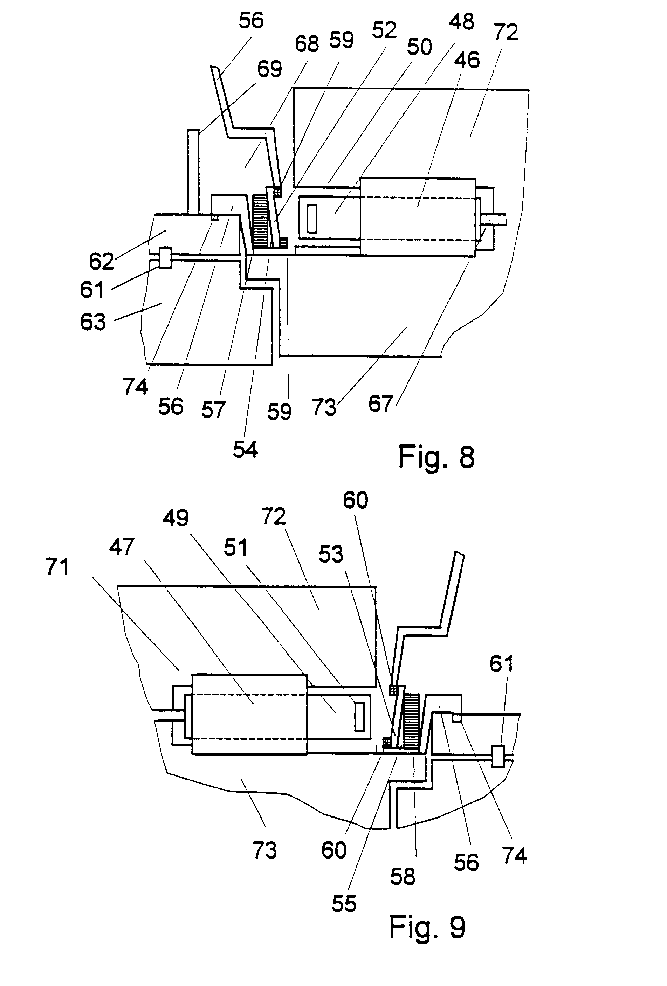

Gemäß den Figuren 7 - 9 sind für die Gaszufuhr und die Gasableitung Andockvorrichtungen 46, 47 an eine SMIF-Box vorgesehen, bei denen linear bewegliche, mit Öffnungen 50, 51 für den Gasein- und -austritt versehene Teile 48, 49 geeignet sind, Verschlüsse 52, 53 für einen Gaszufuhrkanal 54 und einen Gasableitungskanal 55 zu öffnen.
Der Gaszufuhrkanal 54 und Gasableitungskanal 55 sind dem Magazin 3 auf entgegengesetzten Seiten benachbart in die Wandung 56 eingearbeitet. Die Verschlüsse 52, 53 werden durch Federelemente 57, 58 gegen Dichtelemente 59, 60 gedrückt, so daß ohne Betätigung der Andockvorrichtungen 46, 47 die SMIF-Box nach außen verschlossen ist.
Signale von Druckschaltern 61, die im abgesetzten Zustand der SMIF-Box mit ihrem entriegelbaren Boden 62 auf einem absenkbaren Plattenteil 63 betätigt werden, setzen die linear beweglichen Teile 48, 49 in Bewegung und öffnen elektromagnetische Pneumatikventile 64, 65. Der durch ein Filter 66 gereinigte Gasstrom tritt über eine Gasleitung 67 aus der Öffnung 50 in den geöffneten Gaszufuhrkanal 54. Ein Einströmraum 68, ein Diffuser 69 und ein Ausströmraum 70 wirken entsprechend der Lösung gemäß den Figuren 4 - 6. Ausströmendes Gas verläßt über die Öffnung 51 der Andockvorrichtung 47 die SMIF-Box und gelangt in die Gasleitung 71.
Mit 72 ist eine Führungsschiene, mit 73 eine Aufnahmeplatte und mit 74 eine Boxabdichtung bezeichnet.
Die Aufhebung des angedockten Zustandes, für die eine Rückwärtsbewegung der beweglichen Teile 48, 49 erforderlich ist, wird durch einen nicht dargestellten, ausschließlich im geschlossenen Zustand der SMIF-Box 1 betätigbaren Taster oder Schalter ausgelöst.

## Patentansprüche

1. Transportvorrichtung für Magazine zur Aufnahme scheibenförmiger Objekte, bei der ein Gaszufuhrkanal (4, 31, 54) und ein Gasableitungskanal (5, 37, 55) als verschließbare Kanäle in einen Magazinbehälter (1) mit entriegelbarem Boden (16, 33, 62) geführt sind und der Gasableitungskanal (5, 37, 55) mit einem Gasauslaß im Magazinbehälter (1) verbunden ist, **dadurch gekennzeichnet**, daß der Magazinbehälter (1), in dessen Wandung (2, 29, 56) der Gaszufuhrkanal (4, 31, 54) und der Gasableitungskanal (5, 37, 55) eingearbeitet sind, Mittel zur Gasverteilung im wesentlichen auf Räume zwischen den scheibenförmigen Objekten und benachbart zur Grund- und Deckfläche des Magazins (3) enthält, in die der Gaszufuhrkanal (4, 31, 54) mündet, wobei die Mittel zur Gasverteilung und der Gasauslaß dem Magazin (3) benachbart und auf einander gegenüberliegenden Seiten desselben angeordnet sind.

2. Transportvorrichtung nach Anspruch 1, dadurch gekennzeichnet, daß die Mittel zur Gasverteilung aus einer an der Wandung (2) lösbar befestigten Ausströmleiste (11) bestehen, die dicht mit dem Gaszufuhrkanal (4) verbunden ist und in die im wesentlichen auf die Räume zwischen den scheibenförmigen Objekten und benachbart zur Grund- und Deckfläche des Magazins (3) gerichtete Öffnungen zur Gasverteilung eingearbeitet sind, daß der Gasauslaß aus einer an der Wandung (2) lösbar befestigten, Öffnungen zur Gasableitung (14) aufweisenden Ableitungsleiste (13) besteht, die dicht mit dem Gasableitungskanal (5) verbunden ist, und daß die Kanäle (4, 5) selbstschließende Ventile (7, 8) enthalten, die beim Absetzen des Magazinbehälters (1) zu ihrer Öffnung betätigt werden.

3. Transportvorrichtung nach Anspruch 1, dadurch gekennzeichnet, daß als Mittel zur Gasverteilung ein erweiterter Einströmraum (32, 68), dessen Begrenzungen durch abgewinkelte Teile der Wandung (29, 56) gebildet werden, und ein dem Einströmraum (32, 68) in Strömungsrichtung nachgeordneter, auf dem entriegelbaren Boden (33, 62) befestigter Diffusor (34, 69) vorgesehen sind, und daß der Gasauslaß aus einem durch abgewinkelte Teile der Wandung (29, 56) gebildeten erweiterten Ausströmraum (38, 70) besteht, über den der Gasableitungskanal (37, 55) mit dem Innenraum des Magazinbehälters in Verbindung steht.

4. Transportvorrichtung nach Anspruch 3, dadurch gekennzeichnet, daß der Gaszufuhrkanal (31) und der Gasableitungskanal (37) durch gasdruckbetätigbare Einströmventile (30, 36) verschließbar sind.

5. Transportvorrichtung nach Anspruch 4, dadurch gekennzeichnet, daß der Gaszufuhrkanal (54) und der Gasableitungskanal (55) mit Verschlüssen (52, 53) versehen sind, zu deren Betätigung linear bewegliche, mit Öffnungen (50, 51) für einen Gasaus- und -Eintritt versehene Teile (48, 49) von Andockvorrichtungen (46, 47) dienen.

## Claims

1. Transport device for magazines for receiving disc-shaped objects, in which a gas supply channel (4, 31, 54) and a gas discharge channel (5, 37, 55) are passed as closable channels in a magazine container (1) with releasable base (16, 33, 62) and the gas discharge channel (5, 37, 55) is connected to a gas outlet in the magazine container (1), characterised in that the magazine container (1), in the wall (2, 29, 56) of which are provided the gas supply channel (4, 31, 54) and the gas discharge channel (5, 37, 55), contains means for distribution of gas essentially to spaces between the disc-shaped objects and adjacent to the base and top surface of the magazine (3), into which the gas supply channel (4, 31, 54) opens, wherein the means for distribution of gas and the gas outlet are adjacent to the magazine (3) and are disposed on opposing sides of the latter.

2. Transport device as claimed in Claim 1, characterised in that the means for distribution of gas consists of an outflow strip (11) which is releasably fixed on the wall (2), is connected tightly to the gas supply channel (4) and has provided in it openings for distribution of gas which are directed essentially onto the spaces between the disc-shaped objects and adjacent to the base and top surface of the magazine (3), that the gas outlet consists of a discharge strip (13) which is releasably fixed on the wall (2), has openings for discharge (14) of gas and is tightly connected to the gas discharge channel (5), and that the channels (4, 5) contain self-closing valves (7, 8) which are actuated to be opened as the magazine container (1) is set down.

3. Transport device as claimed in Claim 1, characterised in that as means for distribution of gas a widened inflow space (32, 68), the limits of which are formed by bent parts of the wall (292, 56), and a diffuser (34, 69) which is fixed on the releasable base (33, 62) and is arranged downstream of the inflow space (32, 68) in the flow direction, and that the gas outlet consists of an outflow space (338, 70) which is widened by bent parts of the wall (29, 56) and by way of which the gas discharge channel (37, 55) is connected to the interior of the magazine container.

4. Transport device as claimed in Claim 3, characterised in that the gas supply channel (31) and the gas discharge channel (37) can be closed by gas pressure actuated inflow valves (30, 36).

5. Transport device as claimed in Claim 4, characterised in that the gas supply channel (54) and the gas discharge channel (55) are provided with closures (52, 53), and linearly movable parts (48, 49) of docking devices (46, 47) which are provided with openings (50,51) for gas outlet and inlet serve for actuation of the said closures.

## Revendications

1. Dispositif de transport pour des magasins destinés à recevoir des objets en forme de disques dans lequel un canal d'amenée de gaz (4, 31, 54) et un canal d'évacuation de gaz (5, 37, 55), réalisé sous forme de canaux obturables sont guidés dans un récipient à magasin (1) ayant un fond (16, 33, 62) déverrouillable, et le canal d'évacuation de gaz (5, 37, 55) étant relié à un échappement de gaz ménagé dans le récipient à magasin (1), caractérisé en ce que le récipient à magasin (1), dans la paroi (2, 29, 56) duquel sont usinés le canal d'amenée de gaz (4, 31, 54) et le canal d'évacuation de gaz (5, 37, 55), contient des moyens de distribution de gaz sensiblement sur des espaces se trouvant entre les objets en forme de disques et au voisinage de la surface de plancher du plafond du magasin (3), dans laquelle le canal d'amenée de gaz (4, 31, 54) débouche, les moyens de distribution de gaz et l'échappement de gaz étant voisins du magasin (3) et étant disposés sur des côtés mutuellement opposés de celui-ci.

2. Dispositif de transport selon la revendication 1, caractérisé en ce que les moyens de distribution de gaz sont constitués d'une bande de sortie d'écoulement (11) fixée de façon désolidarisable à la paroi (2) et reliée de façon étanche au canal d'amenée de gaz (4) et dans laquelle sont usinées des ouvertures, destinées à la distribution du gaz et orientées sensiblement sur les espaces existants entre les objets en forme de disques et au voisinage de la surface de plancher et de plafond du magasin (3), en ce que l'échappement de gaz est constitué d'une bande de d'évacuation (13) fixée de façon désolidarisable à la paroi (2), présentant des ouvertures allant vers l'évacuation de gaz (14), bande qui est reliée de façon étanche au canal d'évacuation de gaz (5), et en ce que les canaux (4, 5) contiennent des soupapes (7, 8) se fermant d'elles-mêmes, actionnées dans le sens de leur ouverture lors de la dépose du récipient en magasin (1).

3. Dispositif de transport selon la revendication 1, caractérisé en ce que, à titre de moyens pour assurer la distribution du gaz, sont prévus un espace d'introduction d'écoulement (32, 68) agrandi, dont des délimitations sont constituées par des parties coudées de la paroi (29, 56), et un diffuseur (34, 69), fixé sur le fond (33, 62) dévérouillable, disposé en aval de l'espace d'introduction d'écoulement (32, 68) dans la direction de l'écoulement, et en ce que l'échappement de gaz est constitué d'un espace de sortie d'écoulement (38, 70) agrandie constituée par des parties coudées de la paroi (29, 56), espace par l'intermédiaire duquel le canal d'évacuation de gaz (37, 55) est relié à l'espace intérieur du récipient à magasin.

4. Dispositif de transport selon la revendication 3, caractérisé en ce que le canal d'amenée de gaz (31) et le canal d'évacuation de gaz (37) peuvent être obturés par des soupapes d'introduction d'écoulement (30, 66) actionnable par une pression de gaz.

5. Dispositif de transport selon la revendication 4, caractérisé en ce que le canal d'amenée de gaz (54) et le canal d'évacuation de gaz (55) sont pourvus de fermetures (52, 53), pour l'actionnement desquelles sont utilisés des parties (48, 49) mobiles, dotées d'ouvertures (50, 51) pour la sortie et l'entrée des gaz et ces parties appartenant à des dispositifs d'accostage (46, 47).
